# EUROPÄISCHE PATENTSCHRIFT

(11) **EP 0 118 709 B1**
(45) Veröffentlichungstag und Bekanntmachung des Hinweises auf die Patenterteilung: **28.12.1994**
(21) Anmeldenummer: 84100928.5
(22) Anmeldetag: 30.01.1984
(51) Int. Cl.: H01L 29/78, H01L 21/225, H01L 21/285

(54) **Verfahren zum Herstellen von MOS-Transistoren mit flachen Source/Drain-Gebieten, kurzen Kanallängen und einer selbstjustierten, aus einem Metallsilizid bestehenden Kontaktierungsebene**
Process for manufacturing MOS transistors having planar source and drain regions, short channel length and a self-aligned contact level comprising a metallic silicide
Procédé pour la fabrication de transistor MOS à régions de source et drain planaires, à courte longueur de canal et à niveau de contact auto-aligné comportant un siliciure métallique

(30) Priorität: 10.02.1983 DE 3304588
(43) Veröffentlichungstag der Anmeldung: 19.09.1984
(73) Patentinhaber: SIEMENS AKTIENGESELLSCHAFT, 80333 München (DE)
(72) Erfinder: Schwabe, Ulrich, Dr. phil., D-8000 München 83 (DE); Neppl, Franz, Dr. rer. nat., D-8000 München 90 (DE); Bürker, Ulf, Dr. rer. nat., D-8000 München 40 (DE); Christoph, Werner, Dr. rer. nat., D-8033 Krailling (DE)

(56) Entgegenhaltungen:
- EP-A- 0 051 500
- EP-A- 0 081 804
- US-A- 4 364 166
- PATENT ABSTRACTS OF JAPAN, Band 7, Nr. 62 (E-164)[1207], 15. März 1983 ; & JP-A-57 207 374
- EXTENDED ABSTRACTS, Band 82-2, Oktober 1982, Seite 260, Pennington, New Jersey,US; W.I. LEHRER et al.: "Low temperature LPCVD deposition of tantalum silicide"
- IBM TECHNICAL DISCLOSURE BULLETIN, Band 24, Nr. 7A, Dezember 1981, Seiten 3413,3414, New York, US; D.R. CAMPBELL et al.: "Doping procedure for polycide"
- EXTENDED ABSTRACTS, Band 81-1, Mai 1981, Pennington, New Yersey, US; Seiten575-577; S. INOUE et al.: "Phosphorus-doped molybdenum silicide films forVLSIapplications"
- IBM TECHNICAL DISCLOSURE BULLETIN, Band 22, Nr. 9, Februar 1980, Seiten 3970,3971, New York, US; R.M. GEFFKEN et al.: "Self-aligned lift-off techniquefordiffusion and contact"

## Beschreibung

Die vorliegende Patentanmeldung betrifft ein Verfahren zum Herstellen von MOS-Transistoren mit flachen Source/Drain-Gebieten, kurzen Kanallängen und einer selbstjustierten, aus einem Metallsilizid bestehenden Kontaktierungsebene.

Eine Verringerung der Strukturgrößen von integrierten MOS-Schaltungen erfordert auch eine Verminderung der Eindringtiefe der Source/Drain-Diffusionsgebiete. Dadurch bedingt erhöht sich der Serienwiderstand erheblich. Dieser Widerstand verringert die Stromverstärkung des Transistors, so daß ab 1 bis 0,5 µm Kanallänge eine weitere Verkleinerung der Struktur keine Vorteile mehr bietet.

Möglichkeiten, den zu hohen Serienwiderstand der Source/Drain-Gebiete zu reduzieren, sind selbstjustierende Silizidierung dieser Gebiete mit Platinsilizid, wie in einem Aufsatz von Shibata et al. im IEEE, ED 29 (1982) auf den Seiten 531 bis 535 beschrieben ist. Nach der Source/Drain-Implantation wird aus der Gasphase SiO₂ abgeschieden und anschließend anisotrop, das heißt, mit steilen Kanten geätzt, so daß an der Gateflanke eine Kantenbedeckung (Side wall-Spacer-Oxid) erfolgt. Anschließend wird Platin aufgedampft und gesintert. Damit bildet sich selbstjustierend sowohl auf der Gateelektrode als auch auf den Source/Drain-Gebieten eine Silizidschicht aus.

Die Nachteile dieses Verfahrens sind neben einer komplizierten Prozeßführung:
a) ein Verbrauch von Silizium bei der Silizidierung, wodurch Kurzschlußgefahr zum Substrat bei flachen Diffusionsgebieten besteht,
b) die Temperaturbeständigkeit wird nur für Temperaturen kleiner 700°C gewährleistet, und
c) es ist ein aufwendiges Metallisierungssystem mit Diffusionsbarriere erforderlich; durch die Vielfachschicht träten Ätzprobleme auf.

Aus US-A-43 64 166 ist ein Verfahren für die Herstellung einer aus dotiertem Polysilizium und Metallsilizid bestehenden Kontaktierungsebene für integrierte Halbleiterschaltungen bekannt. Dabei wird auf ein Substrat eine Polysiliziumschicht aufgebracht, auf die eine Metallsilizidschicht aufgebracht wird. Bei der Herstellung eines MOS-Transistors erfolgt die Dotierung der Source/Drain-Zonen über die mit einer Dotierung versehene Polysiliziumschicht. Die undotierte Silizidschicht, die vom Substrat durch die Polysiliziumschicht getrennt ist, hat die Funktion einer Kontaktleiterbahn.

Aus IBM Technical Disclosure Bulletin, Bd. 22, Nr. 9, Februar 1980, Seite 3970 bis 3971 ist ein Verfahren zur Herstellung eines Kontaktbereichs in einem Substrat durch Diffusion und eines Kontakts aus Metallsilizid oder hochleitendem Material bekannt. Dabei wird der Kontakt mit Hilfe einer lift-off-Technik selbstjustiert zum Kontaktbereich hergestellt.

Aus EP-A-0 051 500 ist bekannt, daß eine Reoxidation von Metallsilizid möglich ist, wenn das Metallsilizid dotiert ist, und zwar mit einer Dotierstoffkonzentration zwischen 1 x 10²⁰ und 4 x 10²¹ Atomen pro cm³. Es wird insbesondere ausgeführt, daß zur Herstellung einer pn-Diode mit einer Metallsilizidelektrode in einem Siliziumsubstrat zwischen dem Metallsilizid und dem Siliziumsubstrat eine Polysiliziumschicht in einer Dicke zwischen 50 und 300 nm anzuordnen ist. Die Polysiliziumschicht verhindert Sprünge in der Polysiliziumschicht und der Metallsilizidschicht während eines Hochtemperaturschrittes. Die Diode wird durch Ausdiffusion von Dotierstoff aus der Metallsilizidschicht durch die Polysiliziumschicht hindurch in dem Siliziumsubstrat hergestellt.

Aus einem Aufsatz von S. Inoue et al, der in 1046 B Extended Abstracts Vol. 81-1 (1981) May, Pennington, New Jersey, USA, erschienen ist, ist eine Untersuchung von Phosphor-dotiertem Molybdänsilizid für VLSI-Anwendungen bekannt. Dabei wird festgestellt, daß siliziumreiche Molybdänsilizidschichten auf Silizium bei einer Hochtemperaturbehandlung als Doppelschicht aus Molybdänsilizid und Silizium rekristallisieren. Dies ist bei undotierten Metallsilizidschichten für eine Erhöhung des Kontaktwiderstandes verantwortlich. Eine solche Erhöhung des Kontaktwiderstandes zwischen dotiertem Molybdänsilizid und dotiertem Silizium wird jedoch auch bei Hochtemperaturbehandlungen bis zu 1100°C nicht beobachtet.

In der älteren europäischen Patentanmeldung 0 081 804 (Artikel 54 (3)) wird ein Verfahren zur Herstellung benachbarter Wannen bei der Herstellung von hochintegrierten komplementären MOS-Feldeffekttransistorschaltungen beschrieben. Dabei wird zur weitgehenden räumlichen Trennung der Wannen zunächst die p-Wanne hergestellt und gezielt eine Unterätzung der als Implantationsmaske bei der p-Wannenherstellung dienenden Nitridschicht erzeugt. Dadurch wird bei der nachfolgenden Oxidation die Kante der Oxidation um 1 bis 2 µm nach außen verschoben. Die beiden Wannen werden getrennt implantiert und diffundiert. Durch dieses Verfahren wird eine gegenseitige Kompensation der Dotierstoffprofile der p- und n-Wanne vermieden. Die Herstellung der Source/Drain-Bereiche für in den Wannen angeordnete MOS-Transistoren erfolgt durch Ionenimplantation.

Eine weitere Möglichkeit zur Reduzierung der Source/Drain-Serienwiderstände ist, wie bereits in der Patentanmeldung P 32 43 125.2 vorgeschlagen, selbstjustierte Polysiliziumkontakte auf den Source/Drain-Gebieten zu erzeugen, wobei die Source/Drain-Gebiete durch Ausdiffusion aus der dotierten Polysiliziumschicht gebildet werden, die später als Kontaktanschluß dient.

Die Erfindung löst die gestellte Aufgabe der Reduzierung des Flächenwiderstands der Source/Drain-Bereiche bei VLSI (= very large scale integration)-Prozessen zur Herstellung von CMOS-Schaltungen auf eine andere Weise und ist gekennzeichnet durch den Ablauf der folgenden Verfahrensschritte:
a) Herstellen einer p-Wanne (25) durch eine Bor-Ionen-Implantation in einer n-dotierten, auf einem n⁺-dotierten Substrat (21) aufgebrachten, mit einer Oxidschicht (23) bedeckten Epitaxieschicht (22) nach erfolgter Maskierung der übrigen Bereiche mit einer Siliziumnitridmaske (24),
b) Ablösen der Oxidschicht (23), wobei gezielt eine Unterätzung der Siliziumnitridschicht (24) durchgeführt wird,
c) Durchführung eines lokalen Oxidationsprozesses und Eindiffusion der Bor-Ionen bis zu einer Eindringtiefe xⱼₚ, die im Bereich der Dicke der Epitaxieschicht (22) ist,
d) Ablösen der Siliziumnitridmaskierung (24),
e) Herstellen einer n-Wanne (28) durch eine Phosphor- oder Arsen-Ionen-Implantation und anschließender Diffusion in einer wesentlich geringeren Eindringtiefe Xⱼₙ als der p-Wanne (xⱼₚ), wobei xⱼₚ ≧ 4 xⱼₙ ist,
f) Durchführung der Feldimplantation (30) für die n-Kanal-Transistoren im Bereich der p-Wanne (25) nach Entfernung einer bei der lokalen Oxidation erzeugten Oxidschicht (27), Oxidation einer Schicht (27a) und Maskierung der n-Wanne (28) mittels einer Siliziumnitrid- (31) und Photolackschicht (32) und des gesamten Transistorbereiches der n-Kanal-Transistoren in der p-Wanne (25) mit einer Siliziumnitridschicht (31),
g) Herstellen der Feldoxidbereiche (34) mittels lokaler Oxidation unter Verwendung der Siliziumnitridschicht (31) als Maskierung,
h) Entfernen der Siliziumnitridmaskierung (31) und Abätzen des unter der Siliziumnitridmaskierung (31) befindlichen Siliziumoxids (23, 27a),
i) ganzflächige Abscheidung der aus Metallsilizid bestehenden Kontaktierungsebene (35), wobei zur Ermöglichung der Reoxidation die Abscheidung so geführt wird, daß Silizium im Überschuß vorliegt,
j) Arsen-Ionen-Implantation (36) der Metallsilizidschicht (35) im p-Wannenbereich (25) nach erfolgter Photolackmaskierung (37) des n-Wannenbereiches (28),
k) Borionenimplantation (39) der Metallsilizidschicht (35) im n-Wannenbereich (28) nach Ablösung der Photolackmaske (37) und erfolgter Photolackmaskierung (38) des p-Wannenbereiches (25),
l) ganzflächige Abscheidung einer aus SiO₂ bestehenden Isolationsschicht (52),
m) Durchführung einer Photolacktechnik zur Definition der Gatebereiche (45, 46), wobei die Photolackmaske mit Ausnahme der Gatebereiche (45, 46) die über den Source/Drain-Bereichen (41, 42, 41a, 42a) liegende Metallsilizidschicht (35) und die darüberliegende SiO₂-Schicht (52) abdeckt,
n) Durchführung eines Trockenätzverfahrens zur Strukturierung der Metallsilizidschicht (35) und der darüberliegenden SiO₂-Schicht (52) in den Source/Drain-Bereichen (41, 42, 41a, 42a) wobei die Gatebereiche freigelegt werden,
o) Durchführung einer thermischen Behandlung zur Erzeugung des Gateoxids (40) und der Source-Drain-Bereiche (41, 42, 41a, 42a) durch Ausdiffusion der in der Metallsilizidschicht (35) enthaltenen Dotierstoffe,
p) Erzeugen einer Kanalzone (49, 50) in den Gate-Bereichen (45, 46) durch Implantation von Bor,
q) Öffnen der Kontakte zu den p⁺- und n⁺-dotierten Zonen (41a, 42a) ("buried"-Kontakte)
r) ganzflächige Abscheidung der die Gate-Elektroden (45, 46) und die "buried"-Kontakte (43, 44) bildenden Schicht,
s) Strukturierung der Gate-Elektroden (45, 46) und der "buried"-Kontakte (43, 44) so, daß die Source-Drain-Bereiche (41, 42) überlappt werden,
t) Erzeugen einer als Isolationsoxid dienenden Zwischenschicht (47),
u) Öffnen der Kontaktlöcher zu den die Source/Drain-Bereiche (41, 42) bedeckenden Metallsilizidschichtstrukturen (35) und Durchführung der Metallisierung (48) in bekannter Weise.

Der Vorteil der erfindungsgemäßen Verfahrens gegenüber dem in der Patentanmeldung P 32 43 125.2 vorgeschlagenen Verfahrens liegt darin, daß mit Metallsilizid eine weit stärkere Reduzierung der Serienwiderstände bei MOS-Feldeffekttransistoren erreicht wird als mit dotiertem Polysilizium. Infolge der Niederohmigkeit ist auch die Weiterführung des Metallsilizids als Verdrahtung auf Dickoxidbereichen vorteilhaft. Da die Leitfähigkeit des Metallsilizids nicht von der Dotierstoffkonzentration abhängt, ist eine relativ schwache Dotierung durch Ausdiffusion möglich. Dies erhöht die "avalanche"-Durchbruchsspannung. Da bei der entscheidenden Ätzung der Silizidstrukturierung nicht eine Siliziumätzung auf Silizium gestopt werden muß, sondern unterschiedliche Materialien vorliegen, nämlich Silizium und Metallsilizid, ist ein Ätzprozeß mit höherer Selektivität oder zumindest eine leichtere Endpunktkontrolle möglich.

Weitere Ausgestaltungen des Erfindungsgedankens sind in Unteransprüchen gekennzeichnet.

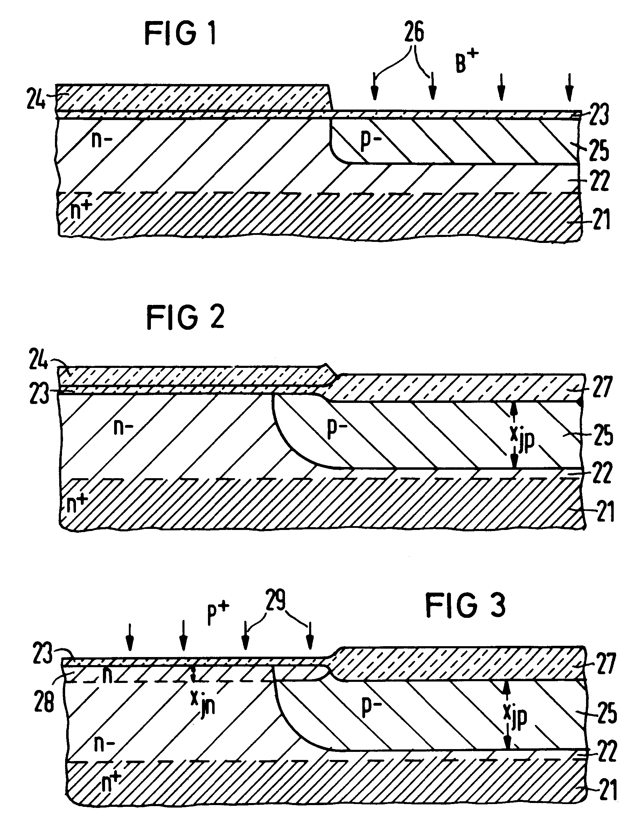

Im folgenden wird anhand der Figuren 1 bis 8 die Erfindung noch näher erläutert. Dabei zeigen
die Figuren 1 bis 8 die erfindungswesentlichen Verfahrensschritte bei der Herstellung einer CMOS-Transistorschaltung mit "buried"-Kontakten, wozu das Verfahren nach der Lehre der Erfindung besonders gut geeignet ist, weil mit dem Silizid ein "buried"-Kontakt bei p- und bei n-Kanaltransistoren möglich ist, während bei Verwendung von Polysilizium dies für n-Kanaltransistoren gilt.

Figur 1: Zu Beginn der Prozeßfolge wird die p-Wanne (25) hergestellt. Dabei wird von einem, mit einer n-dotierten Epitaxieschicht 22 (<100>-Si, 10 bis 50 Ohm cm) versehenen, n⁺-dotierten Substrat 21 (<100>-Si, 0,01 bis 0,1 Ohm cm) ausgegangen, welches mit einer Oxidschicht 23 (50 nm) und mit einer, mit Hilfe einer Photolacktechnik (nicht abgebildet) strukturierten Siliziumnitridschicht 24 von 100 nm Dicke versehen ist. Die Bor-Ionen-Implantation 26 zur Erzeugung der p-Wanne 25 erfolgt mit einer Dosis und Energie von 1,5 x 10¹²cm⁻² bzw. 160 keV.

Figur 2: Nach dem Ablösen der Oxidschicht 23, wobei gezielt eine Unterätzung der Siliziumnitridschicht 24 durchgeführt wird, erfolgt ein Oxidationsprozeß. Die neu erzeugte Oxidschicht ist mit 27 bezeichnet und weist eine Dicke von 400 nm auf. In einem nachfolgenden Diffusionsprozeß werden die Bor-Ionen bis zu einer Eindringtiefe xⱼₚ von 6 µm in die Epitaxieschicht 22 eindiffundiert. Die Dicke der Epitaxieschicht 22 beträgt 7 µm.

Figur 3: Die Siliziumnitridschicht 24 wird entfernt. Die Herstellung der n-Wanne 28 erfolgt durch eine ganzflächige Phosphor- oder Arsen-Ionenimplantation 29 mit einer Implantationsdosis und Energie von 9 x 10¹¹cm⁻² bzw. 60 keV und anschließender Eindiffusion bis zu einer Eindringtiefe xⱼₙ von 1 bis 1,5 µm. Infolge der hohen Implantationsdosis kann die Feldionenimplantation für die Einstellung der Einsatzspannung der p-Kanaldickoxidtransistoren eingespart werden und damit eine zusätzliche Maske.

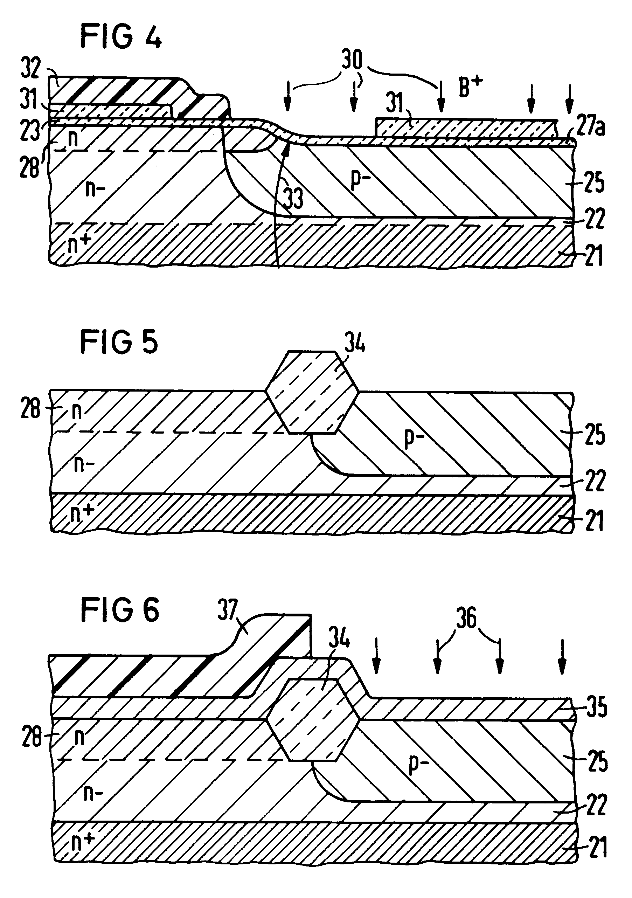

Figur 4: Nach dem Eintreiben der Phosphor- bzw. Arsen-Ionen für die n-Wanne 28 wird die Oxidschicht abgeätzt und es folgen die Oxidation der Schicht 27a (50 nm) und die Siliziumnitridabscheidung 31 in einer Schichtdicke von 120 nm und die Strukturierung der Siliziumnitridschicht (Maske LOCOS). Die Feldimplantation der p-Wanne 25 mit Bor-Ionen erfolgt nach Maskierung der n-Wanne 28 und des gesamten Transistorbereichs der n-Kanaltransistoren in der p-Wanne 25 der Siliziumnitridschicht 31. Alle Bereiche außer den p-Wannenbereichen werden während der Bor-Ionenimplantation 30 mit einer Photolackstruktur 32 abgedeckt. Die Implantationsdosis und Energie der Bor-Ionenimplantation 30 wird auf 1 x 10¹³ cm⁻² und 25 keV eingestellt. Die mit dem Pfeil 33 in Figur 4 angezeigte Oberflächenkante wird in den folgenden Figuren vernachläßigt.

Figur 5: Nach Entfernung der Photolackstruktur 32 werden dann unter Verwendung der Siliziumnitridschicht 31 als Maskierung die Feldoxidbereiche 34 in einer Schichtdicke von 1000 nm durch lokale Oxidation erzeugt. Nach Ablösung der Siliziumnitridschicht 31 wird auch das unter der Siliziumnitridschicht 31 befindliche dünne Oxid (23, 27) entfernt, wobei die in Figur 5 dargestellte Anordnung entsteht.

Figur 6: Es erfolgt nun eine ganzflächige Abscheidung einer aus Tantal und Silizium (oder Titan, Molybdän oder Wolfram und Silizium) bestehenden Metallsilizidschicht 35 in einer Schichtdicke von 200 nm, wobei zur Ermöglichung der Reoxidation die Abscheidung so geführt wird, daß bezüglich der Stöchiometrie Silizium im Überschuß vorliegt. Dies kann auch durch eine Vorabscheidung von reinem Silizium erreicht werden. Die Tantal-Silizid-Schicht 35 wird dann mittels einer Arsen-Ionen-Implantation 36 dotiert (5 x 10¹⁵ cm⁻², 80 keV), nachdem vorher der n-Wannenbereich 28 mit einer Photolackmaske 37 abgedeckt worden ist.

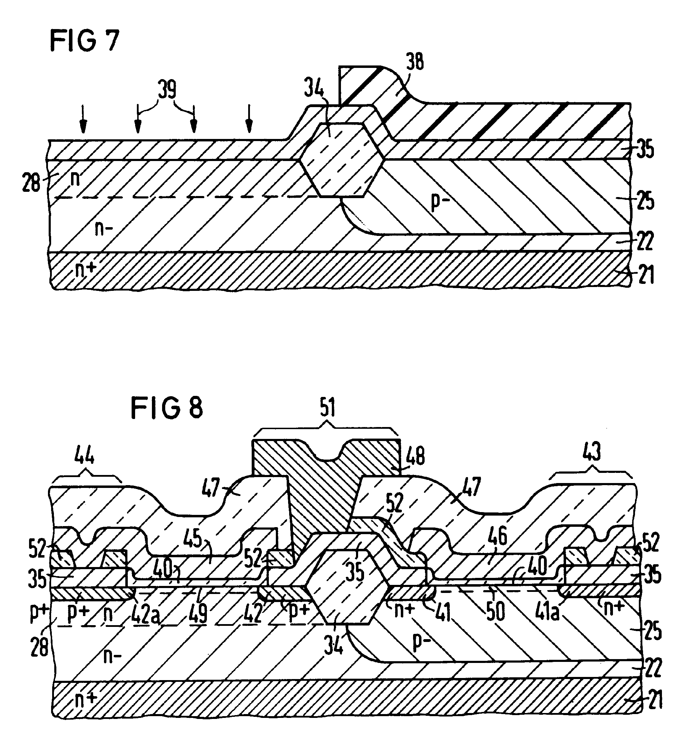

Figur 7: Nach Ablösung der Photolackmaske 37 wird im p-Wannenbereich 25 eine weitere Photolackmaske 38 aufgebracht und anschließend die Tantalsilizidschicht 35 im n-Wannenbereich durch Implantation von Bor-Ionen 39 dotiert (5 x 10¹⁵ cm⁻², 25 keV). Die Photolackmaske 39 wird nach der Dotierung entfernt.

Nun erfolgt die Durchführung einer Photolacktechnik zur Definition der Gatebereiche, wobei die Photolackmaske mit Ausnahme der Gatebereiche die über den Source/Drain-Bereichen liegende Metallsilizidschicht 35 und die darüberliegende SiO₂-Schicht 52 abdeckt. Mittels eines Trockenätzverfahrens wird die Metallsilizidschicht 35 mit der darüberliegenden SiO₂-Schicht 52 in den Source/Drain-Bereichen strukturiert, wobei die Gatebereiche freigelegt werden. Es entstehen die mit dem Bezugszeichen 35 in Figur 7 bezeichneten Tantalsilizidschichtstrukturen.

Figur 8: Zur Ausdiffusion der in den Tantalsilizidschichtstrukturen (35) enthaltenen Dotierstoffen (Bor und Arsen) und zur Erzeugung des Gateoxids 40 wird nun eine thermische Behandlung bei 900°C durchgeführt. Dabei entstehen die Source/Drain-Bereiche 41 (n⁺) und 42 (p⁺) und die Silizidflanken werden oxidiert. Durch Implantation von Bor-Ionen werden in den Gatebereichen (45, 46) die Kanalzonen 49, 50 erzeugt und anschließend Kontakte zu den p⁺- (42a) und n⁺ (41a)-dotierten Zonen (41a, 42a) geöffnet (sogenannte "buried"-Kontakte 43, 44). Nun wird die die Gateelektroden 45, 46 und die die "buried"-Kontakte 43, 44 bildende Polysiliziumschicht ganzflächig abgeschieden und diese Schicht so strukturiert, daß die Gateelektroden 45, 46 und die "buried"-Kontakte 43, 44 die Source/Drain-Bereiche 41 und 42 überlappen.

Nach Erzeugen einer als Isolationsoxid dienenden Zwischenschicht 47 werden die Kontaktlöcher zu den die Source/DrainBereiche 41, 42 bedeckenden Metallsilizidschichtstrukturen 35 geöffnet und die aus Aluminium bestehenden Kontaktleiterbahnebene 48 gebildet.

Die geschweiften Klammern 43, 44 und 51 haben folgende Bedeutung:
43 zeigt den "buried"-Kontakt auf dem n⁺-dotierten Gebiet 41a,
44 den "buried"-Kontakt auf dem p⁺-dotierten Gebiet 42a und
51 den Bereich des überlappenden Kontaktes Aluminium 48 auf dem Source/Drain-Gebiet 41, 42.

Durch den vorgeschlagenen Silizidprozeß bei der Herstellung einer CMOS-Transistorschaltung ergeben sich zusammenfassend folgende device-relevanten Vorteile gegenüber bekannten Anordnungen:
1. die Source/Drain-Gebiete (41, 42) sind um eine Größenordnung niederohmiger;
2. man erhält eine nahezu unabhängige, zusätzliche, niederohmige Verdrahtung durch Silizid (35) ohne Mehraufwand;
3. durch überlappende Kontakte (51) aus der Aluminiumebene (48) zu den Source/Drain-Gebieten (41, 42) und die dadurch mögliche Reduzierung der Größe der Source/Drain-Bereiche entstehen geringere "junction"-Kapazitäten und höhere Packungsdichte;
4. da die Kanalimplantation (49, 50) nach der Silizidstrukturierung und damit wirklich nur im Kanalbereich selbst erfolgen kann, treten geringere "junction"-Kapazitäten und "avalance"-Anfälligkeit auf;
5. da eine schwache Dotierung der Source/Drain-Gebiete möglich ist, entsteht eine geringere "avalance"-Anfälligkeit und flache Diffusionsgebiete;
6. bei CMOS ist eine direkte Verbindung zwischen n⁺-Source/Drain (43)- und p⁺-Source/Drain-Gebieten (44) durch Silizid (35) möglich, wodurch ein platzsparendes Design geschaffen wird.
7. Dieses Design wird auch ermöglicht durch die "buried"-Kontakte sowohl zu p⁺- als auch zu n⁺-Bereichen, daher platzsparend.
8. Der Prozeß ist ohne weiteres auf einem latch-up-freien CMOS-Prozeß mit Schottky-MOSFETs abänderbar. Dazu muß nur die Siliziddotierung, zum Beispiel im p-Kanal-Transistorbereich unterbleiben.

## Patentansprüche

1. Verfahren zum Herstellen von p- und n-Kanal-MOS-Transistoren enthaltenden Schaltungen (CMOS-Schaltungen) in VLSI-Technologie mit flachen Source/Drain-Gebieten, kurzen Kanallängen und einer selbstjustierten, aus einem Metallsilizid bestehenden Kontaktierungsebene,
**gekennzeichnet durch** den
Ablauf der folgenden Verfahrensschritte:
a) Herstellen einer p-Wanne (25) durch eine Bor-Ionen-Implantation in einer n-dotierten, auf einem n⁺ -dotierten Substrat (21) aufgebrachten, mit einer Oxidschicht (23) bedeckten Epitaxieschicht (22) nach erfolgter Maskierung der übrigen Bereiche mit einer Siliziumnitridmaske (24),
b) Ablösen der Oxidschicht (23), wobei gezielt eine Unterätzung der Siliziumnitridschicht (24) durchgeführt wird,
c) Durchführung eines lokalen Oxidationsprozesses und Eindiffusion der Bor-Ionen bis zu einer Eindringtiefe xⱼₚ, die im Bereich der Dicke der Epitaxieschicht (22) ist,
d) Ablösen der Siliziumnitridmaskierung (24),
e) Herstellen einer n-Wanne (28) durch eine Phosphoroder Arsen-Ionen-Implantation und anschließender Diffusion in einer wesentlich geringeren Eindringtiefe xⱼₙ als der p-Wanne (xⱼₚ), wobei xⱼₚ ≧ 4 xⱼₙ ist,
f) Durchführung der Feldimplantation (30) für die n-Kanal-Transistoren im Bereich der p-Wanne (25) nach Entfernung einer bei der lokalen Oxidation erzeugten Oxidschicht (27), Oxidation einer Schicht (27a) und Maskierung der n-Wanne (28) mittels einer Siliziumnitrid- (31) und Fotolackschicht (32) und des gesamten Transistorbereiches der n-Kanal-Transistoren in der p-Wanne (25) mit einer Siliziumnitridschicht (31),
g) Herstellen der Feldoxidbereiche (34) mittels lokaler Oxidation unter Verwendung der Siliziumnitridschicht (31) als Maskierung,
h) Entfernen der Siliziumnitridmaskierung (31) und Abätzen des unter der Siliziumnitridmaskierung (31) befindlichen Siliziumoxids (23, 27a),
i) ganzflächige Abscheidung der aus Metallsilizid bestehenden Kontaktierungsebene (35), wobei zur Ermöglichung der Reoxidation die Abscheidung so geführt wird, daß Silizium im Überschuß vorliegt,
j) Arsen-Ionen-Implantation (36) der Metallsilizidschicht (35) im p-Wannenbereich (25) nach erfolgter Fotolackmaskierung (37) des n-Wannenbereiches (28),
k) Borionenimplantation (39) der Metallsilizidschicht (35) im n-Wannenbereich (28) nach Ablösung der Fotolackmaske (37) und erfolgter Fotolackmaskierung (38) des p-Wannenbereiches (25),
l) ganzflächige Abscheidung einer aus SiO₂ bestehenden Isolationsschicht (52),
m) Durchführung einer Fotolacktechnik zur Definition der Gatebereiche (45, 46), wobei die Fotolackmaske mit Ausnahme der Gatebereiche (45, 46) die über den Source/Drain-Bereichen (41, 42, 41a, 42a) liegende Metallsilizidschicht (35) und die darüberliegende SiO₂-Schicht (52) abdeckt,
n) Durchführung eines Trockenätzverfahrens zur Strukturierung der Metallsilizidschicht (35) und der darüberliegenden SiO₂Schicht (52) in den Source/Drain-Bereichen (41, 42, 41a, 42a) wobei die Gate-bereiche freigelegt werden,
o) Durchführung einer thermischen Behandlung zur Erzeugung des Gateoxids (40) und der Source-Drain-Bereiche (41, 42, 41a, 42a) durch Ausdiffusion der in der Metallsilizidschicht (35) enthaltenen Dotierstoffe,
p) Erzeugen einer Kanalzone (49, 50) in den Gate-Bereichen (45, 46) durch Implantation von Bor,
q) Öffnen der Kontakte zu den p⁺- und n⁺-dotierten Zonen (41a, 42a) ("buried"-Kontakte)
r) ganzflächige Abscheidung der die Gate-Elektroden (45, 46) und die "buried"-Kontakte (43, 44) bildenden Schicht,
s) Strukturierung der Gate-Elektroden (45, 46) und der "buried"-Kontakte (43, 44) so, daß die Source-DrainBereiche (41, 42) überlappt werden,
t) Erzeugen einer als Isolationsoxid dienenden Zwischenschicht (47),
u) Öffnen der Kontaktlöcher zu den die Source-Drain-Bereiche (41, 42) bedeckenden Metallsilizidschichtstrukturen (35) und Durchführung der Metallisierung (48) in bekannter Weise.

2. Verfahren nach Anspruch 1,
**dadurch gekennzeichnet**,
daß für die ganzflächige Abscheidung der die Gate-Elektroden (45, 46) und die "buried"-Kontakte (43, 44) bildenden Schicht nach Verfahrensschritt r) Polysilizium, hochschmelzende Metalle und/oder Metallsilizid verwendet werden.

3. Verfahren nach Anspruch 1 und/oder 2,
**dadurch gekennzeichnet**,
daß die Metallisierung nach Verfahrensschritt u) mit Aluminium (48) als Kontaktleiterbahnebene durchgeführt wird.

4. Verfahren nach einem der Ansprüche 1 bis 3,
**dadurch gekennzeichnet**,
daß als Metallsilizid (3, 35) die Silizide der Metalle Tantal, Titan, Molybdän oder Wolfram verwendet werden.

5. Verfahren nach einem der Ansprüche 1 bis 4,
**dadurch gekennzeichnet**,
daß der Überschuß an Silizium dadurch erzeugt wird, daß vor der Abscheidung des Metallsilizids (3, 35) Polysilizium abgeschieden wird.

6. Verfahren nach einem der Ansprüche 1 bis 5,
**dadurch gekennzeichnet**,
daß die Dotierung des Silizids (3, 35) durch Ionenimplantation nach der Metallsilizidabscheidung erfolgt.

7. Verfahren nach einem der Ansprüche 1 bis 5,
**dadurch gekennzeichnet**,
daß die Dotierung des Metallsilizids (3, 35) bei der Silizidabscheidung durch reaktives Zerstäuben (Aufsputtern) von undotiertem Silizium in einer Dotierstoff enthaltenden Atmosphäre erfolgt.

8. Verfahren nach einem der Ansprüche 1 bis 5,
**dadurch gekennzeichnet**,
daß die Dotierung des Metallsilizids (3, 35) durch Zerstäuben erfolgt, wobei ein dotiertes Silizidtarget verwendet wird.

9. Verfahren nach einem der Ansprüche 1 bis 8,
**dadurch gekennzeichnet**,
daß als Dotierstoffe für die Metallsilizidschicht (3) Bor, Arsen oder Phosphor verwendet werden.

## Claims

1. Method for the production of circuits containing p-channel and n-channel MOS transistors (CMOS circuits) using VLSI technology with flat source/drain regions, short channel lengths and a self-adjusting contact-making plane composed of metal silicide, characterized by the sequence of the following method steps:
a) production of a p-well (25) by boron-ion implantation in an n-doped epitaxial layer (22), which is deposited on an n⁺-doped substrate (21) and is covered by an oxide layer (23), after the other regions have been masked with a silicon-nitride mask (24),
b) dissolving of the oxide layer (23), underetching of the silicon-nitride layer (24) being carried out deliberately,
c) carrying out a local oxidation process and diffusion of the boron ions to a penetration depth xⱼₚ, which is in the region of the thickness of the epitaxial layer (22),
d) dissolving the silicon-nitride masking (24),
e) production of an n-well (28) by phosphorus-ion or arsenic-ion implantation and subsequent diffusion with a considerably smaller penetration depth xⱼₙ than the p-well (xⱼₚ), where xⱼₚ ≧ 4xⱼₙ,
f) carrying out the field implantation (30) for the n-channel transistors in the region of the p-well (25) after removal of an oxide layer (27) produced during the local oxidation, oxidation of a layer (27a) and masking of the n-well (28) by means of a silicon-nitride layer (31) and photoresist layer (32) and of the entire transistor region of the n-channel transistors in the p-well (25) with a silicon-nitride layer (31),
g) production of the field-oxide regions (34) by means of local oxidation using the silicon-nitride layer (31) as masking,
h) removing of the silicon-nitride masking (31) and etching away the silicon oxide (23, 27a) located under the silicon-nitride masking (31),
i) deposition of the contact-making plane (35), which is composed of metal silicide, over the entire area, the deposition being carried out such that excess silicon is present, in order to allow re-oxidation,
j) arsenic-ion implantation (36) in the metal-silicide layer (35) in the p-well region (25) after the photo-resist masking (37) of the n-well region (28) has been carried out,
k) boron-ion implantation (39) of the metal-silicide layer (35) in the n-well region (28) after dissolving the photoresist mask (37) and after the photoresist masking (38) of the p-well region (25) has been carried out,
l) deposition of an insulation layer (52), composed of SiO₂, over the entire area,
m) carrying out a photoresist technique in order to define the gate regions (45, 46), the photoresist mask covering, with the exception of the gate regions (45, 46), the metal-silicide layer (35) located over the source/drain regions (41, 42, 41a, 42a) and the SiO₂ layer (52) located on top of said metal-silicide layer (35),
n) carrying out a dry-etching process in order to structure the metal-silicide layer (35) and the SiO₂ layer (52), located on top of said metal-silicide layer (35), in the source/drain regions (41, 42, 41a, 42a), the gate regions being exposed,
o) carrying out a heat treatment in order to produce the gate oxide (40) and the source/drain regions (41, 42, 41a, 42a) by outward diffusion of the dopants contained in the metal-silicide layer (35),
p) production of a channel zone (49, 50) in the gate regions (45, 46) by implantation of boron,
q) opening of the contacts to the p⁺-doped and n⁺-doped zones (41a, 42a) ("buried" contacts),
r) deposition over the entire area of the layer which forms the gate electrodes (45, 46) and the "buried" contacts (43, 44),
s) structuring of the gate electrodes (45, 46) and of the "buried" contacts (43, 44) such that the source/drain regions (41, 42) are overlapped,
t) production of an intermediate layer (47) which is used as insulation oxide,
u) opening of the contact holes to the metal-silicide layer structures (35) which cover the source/drain regions (41, 42), and carrying out the metallization (48) in a known manner.

2. Method according to Claim 1, characterized in that, after method step r), polysilicon, high-melting-point metals and/or metal silicide are used for deposition over the entire area of the layer which forms the gate electrodes (45, 46) and the "buried" contacts (43, 44).

3. Method according to Claim 1 and/or 2, characterized in that the metallization after method step u) is carried out using aluminium (48) as the contact conductor interconnect plane.

4. Method according to one of Claims 1 to 3, characterised in that the silicides of the metals tantallum, titanium, molybdenum or tungsten are used as the metal silicide (3, 35).

5. Method according to one of Claims 1 to 4, characterized in that the excess silicon is produced by polysilicon being deposited before the deposition of the metal silicide (3, 35).

6. Method according to one of Claims 1 to 5, characterized in that the doping of the silicide (3, 35) is carried out by ion implantation after the metal-silicide deposition.

7. Method according to one of Claims 1 to 5, characterized in that the doping of the metal silicide (3, 35) is carried out during the silicide deposition by reactive sputtering of undoped silicon in an atmosphere containing dopant.

8. Method according to one of Claims 1 to 5, characterized in that the doping of the metal silicide (3, 35) is carried out by sputtering, a doped silicide target being used.

9. Method according to one of Claims 1 to 8, characterized in that boron, arsenic or phosphorus are used as dopants for the metal-silicide layer (3).

## Revendications

1. Procédé pour fabriquer des circuits (circuits CMOS) contenant des transistors MOS à canal p et à canal n, selon la technologie VLSI, avec des régions de source/drain plates, de courtes longueurs de canal et un plan de contact auto-aligné, constitué par un siliciure métallique, caractérisé par l'exécution des étapes opératoires suivantes :
a) fabrication d'une cuvette de type p (25) au moyen d'une implantation d'ions de bore dans une couche épitaxiale (22), déposée sur un substrat (21) dopé du type n⁺ et recouverte d'une couche d'oxyde (23), après masquage des autres zones avec un masque de nitrure de silicium (21),
b) élimination de la couche d'oxyde (23), avec exécution désirée d'une corrosion sous-jacente de la couche de nitrure de silicium (24),
c) exécution d'un processus d'oxydation locale et diffusion des ions de bore jusqu'à une profondeur de pénétration xⱼₚ, qui est de l'ordre de l'épaisseur de la couche épitaxiale (22),
d) élimination du masque de nitrure de silicium (24),
e) fabrication d'une cuvette de type n (28) au moyen d'une implantation d'ions de phosphore ou d'arsenic et diffusion ultérieure à une profondeur de pénétration xⱼₙ nettement plus faible que dans le cas de la cuvette de type p (xⱼₚ), avec xⱼₚ ≧ 4 xⱼₙ,
f) exécution de l'implantation de champ (30) pour les transistors à canal n dans la zone de la cuvette de type p (25) après élimination d'une couche d'oxyde (27) produite lors de l'oxydation locale, oxydation d'une couche (27a) et masquage de la cuvette de type n (28) au moyen d'une couche de nitrure de silicium (31) et d'une couche de photolaque (32) et de l'ensemble de la région des transistors à canal n dans la cuvette de type p (25) avec une couche de nitrure de silicium (31),
g) fabrication des zones d'oxyde de champ (34) au moyen d'une oxydation locale moyennant l'utilisation de la couche de nitrure de silicium (31) en tant que masque,
h) élimination du masque de nitrure de silicium (31) et élimination, par corrosion, de l'oxyde de silicium (23, 27a) situé au-dessous du masque de nitrure de silicium (31),
i) dépôt, sur toute la surface, du plan de contact (35) constitué par un siliciure métallique, le dépôt étant exécuté, afin de permettre la réoxydation, de manière que du siliciure soit présent en excès,
j) implantation (36) d'ions d'arsenic dans la couche de siliciure métallique (35) dans la région de cuvette de type p (25) après masquage (37) de la région de cuvette de type n (28) avec une photolaque,
k) implantation (39) d'ions de bore dans la couche de siliciure métallique (35) dans la région de cuvette de type n (28) après élimination du masque de photolaque (37) et masquage (38) de la région de cuvette de type p (25) avec une photolaque,
l) dépôt, sur toute la surface, d'une couche isolante (52) formée de SiO₂,
m) mise en oeuvre d'une technique utilisant une photolaque pour définir les régions de grille (45,46), le masque de photolaque recouvrant, en dehors des régions de grille (45,46), la couche de siliciure métallique (35) située au-dessus des régions de source/drain (41,42, 41a, 42a) et la couche surjacente de SiO₂ (52),
n) exécution d'un procédé de corrosion à sec pour structurer la couche de siliciure métallique (35) et la couche surjacente de SiO₂ (52) dans les régions de source/drain (41,42, 41a, 42a), avec mise à nu des régions de grille,
o) exécution d'un traitement thermique pour l'obtention de l'oxyde de grille (40) et des régions de source - drain (41,42, 41a, 42a) par diffusion des substances dopantes contenues dans la couche de siliciure métallique (35),
p) production d'une zone de canal (42, 50) dans les régions de grille (45,46) par implantation de bore,
q) ouverture du contact en direction des zones dopées de type p⁺ et n⁺ (41a, 42a) (contacts "ensevelis"),
r) dépôt, sur toute la surface, de la couche constituant les électrodes de grille (45,46) et les contacts "ensevelis" (43,44),
s) structuration des électrodes de grille (45,46) et des contacts "ensevelis" (43,44) de manière à obtenir un chevauchement sur les régions de source/drain (41,42),
t) production d'une couche intermédiaire (47) servant d'oxyde isolant,
u) ouverture des trous de contact aboutissant aux structures (35) de la couche de siliciure métallique, recouvrant les régions de source/drain (41,42) et exécution de la métallisation (48) d'une manière connue.

2. Procédé selon la revendication 1, caractérisé par le fait
que pour le dépôt, sur toute la surface, de la couche constituant les électrodes de grille (45,46) et les contacts "ensevelis" (43,44), conformément à l'étape opératoire r), on utilise du polysilicium, des métaux à point de fusion élevé et/ou des siliciures métalliques.

3. Procédé suivant la revendication 1 et/ou 2, caractérisé par le fait que la métallisation est exécutée conformément à l'étape opératoire u) avec de l'aluminium (48) sous la forme d'un plan de voies conductrices de contact.

4. Procédé suivant l'une des revendications 1 à 3, caractérisé par le fait qu'on utilise comme siliciure métallique (3,35), les siliciures des métaux : tantale, titane, molybdène et tungstène.

5. Procédé suivant l'une des revendications 1 à 4, caractérisé par le fait que l'excès de siliciure est produit par le fait qu'avant le dépôt du siliciure métallique (3,35), on dépose du polysilicium.

6. Procédé suivant l'une des revendications 1 à 5, caractérisé par le fait que le dopage du siliciure (3,35) est réalisé au moyen d'une implantation ionique après le dépôt du siliciure métallique.

7. Procédé suivant l'une des revendications 1 à 5, caractérisé par le fait que le dopage du siliciure métallique (3,35) lors du dépôt du siliciure s'effectue au moyen d'une pulvérisation réactive (dépôt par pulvérisation cathodique) de silicium non dopé, dans une atmosphère contenant de l'azote.

8. Procédé suivant l'une des revendications 1 à 5, caractérisé par le fait que le dopage du siliciure métallique (3,35) s'effectue au moyen d'une pulvérisation, moyennant l'utilisation d'une cible de siliciure dopée.

9. Procédé suivant l'une des revendications 1 à 8, caractérisé par le fait qu'on utilise du bore, de l'arsenic ou du phosphore comme substances dopantes pour la couche de siliciure métallique (3).
